# EUROPEAN PATENT APPLICATION

(11) **EP 1 276 234 A1**
(43) Date of publication of application: **15.01.2003**
(21) Application number: 02254411.8
(22) Date of filing: 24.06.2002
(51) Int. Cl.: H03G 3/30, H03G 3/20, H04B 7/005

(54) **Power control for non-constant envelope modulation**

(30) Priority: 10.07.2001 GB 0116808
(71) Applicant: MATSUSHITA ELECTRIC INDUSTRIAL CO., LTD., Kadoma-shi, Osaka 571-8501 (JP)
(72) Inventor: Haigh, Peter, Matsushita Communication Ind. UK Ltd, Thatcham, Berkshire RG19 4ZD (GB)
(74) Representative: Dawson, Elizabeth Ann

(57) **Abstract**

A method and means of controlling power of a burst transmission for non- constant envelope modulation (e.g. EDGE). Power variations are smaller during the training sequence central to the burst and therefore control of transmitted power occurs during the transmission of the training sequence. Estimates of the power in known training sequences are saved in a look up table. The power within message sequences to be transmitted is computed at baseband and compared with the training sequence power. The power level is set in accordance with the relationship between the training sequence and message sequence computations. Power computations are obtained from a series of integer metrics, 1 to 4, assigned according to the type of symbol to symbol transitions occurring.

## Description

This invention relates to communications devices and in particular it relates to the control of a power amplifier in a transmitter.

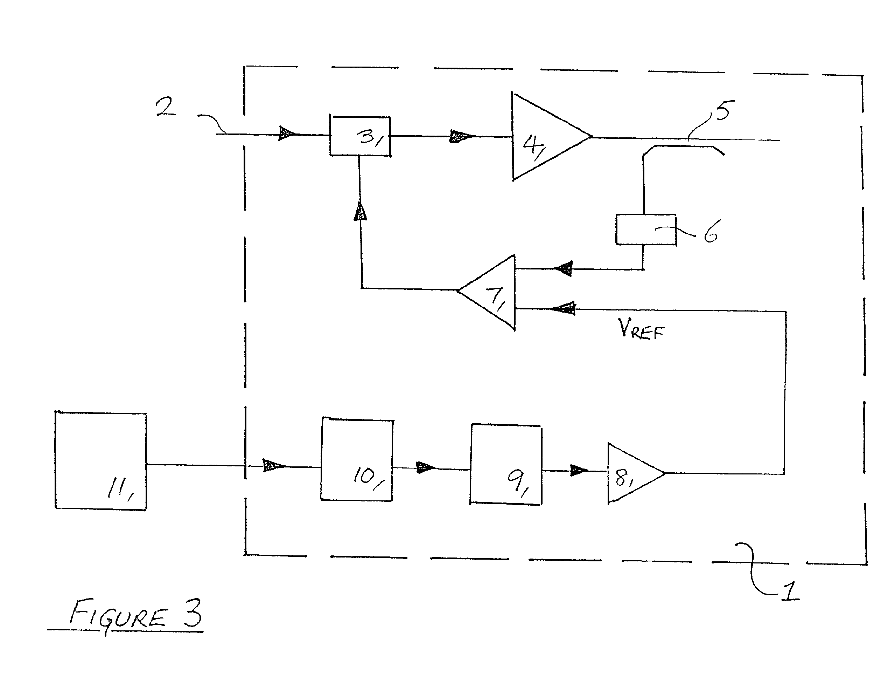

The transmissions to and from portable communication devices operating within a network are required to remain within specified power levels. Measurement and control of the power levels in a GSM portable are effected usually by means of a closed loop control circuit such as that described below in relation to figure 3. A closed loop control is needed to accommodate component tolerances and temperature variations as well as the non-linear operation of the power amplifier. Owing to the constant envelope characteristics of GSM transmissions, established power control methods have proved generally to be satisfactory.

With the advent of portable communication devices using non-constant envelope modulation, however, prior art power control methods are insufficient. An example of a non constant modulation technique for which improved power control methods are needed is specified in ETSI publication GSM 05.04 Digital cellular telecommunications system (Phase 2+); Modulation. Background information on power control for non-constant envelope modulation is available from the published pamphlet WO 01/03292.

Accurate control of transmitted power is necessary for compliance with system requirements and is desirable for the reduction of performance margins. The market conditions for portable communications equipment force close attention to reduction of unit costs. Therefore the use of additional components or a significant increase in processing to achieve power control should be avoided particularly with regard to portable equipment.

One of a set of known sequences of data included in each transmitted burst is provided as a means for estimation of the channel impulse response at the receiver and can assist in receiver synchronisation. These known sequences are called training sequences. As the characteristics of the training sequence included in a burst transmission are known then these characteristics may be used to advantage when setting and controlling the power within a burst.

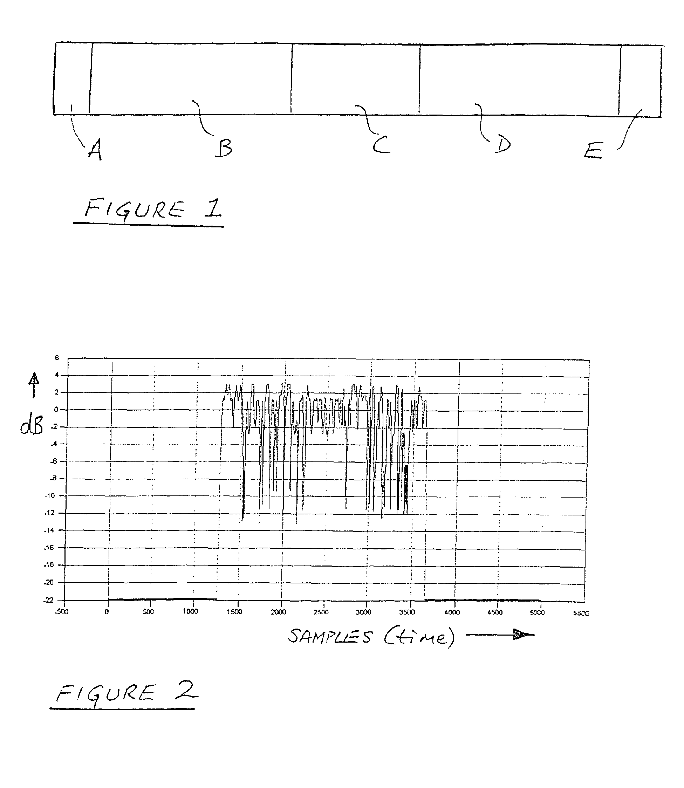

A typical burst transmission as represented in figure 1 has 9 bits at each of the start of the burst **A** and the end of the burst **E.** The purpose of the start bits **A** and tail bits **E** is to allow for the transition from no output to full power. The 174 bits following the start bits and shown as **B** are part of the message data unknown to the receiver and these data are effectively in the format of a pseudo-random sequence. At the middle of the burst the training sequence **C** comprises 78 bits. The training sequence is known to the receiver and is used at the receiver for estimation of the channel impulse response. A further pseudo-random sequence of message data **D** follows the training sequence and is in turn followed by the tail bits **E.**

It is an object of this invention to provide an improved method and means for controlling the power of a burst transmission of a signal having non-constant envelope modulation.

According to the invention there is provided a method of controlling power of a burst transmission including message and training data sequences, comprising computation of estimates of burst power from the characteristics of the sequences of symbols to be transmitted, setting the power level in accordance with a correlative relationship of power between estimates obtained for said message and training sequences and controlling the transmitted power during part of the transmitted burst.

According to a further aspect of the invention there is provided a portable communications terminal incorporating a burst transmitter power control means consisting of a closed loop operating during part of the burst transmission to maintain output power level in accordance with a reference voltage, the level of said reference voltage being set in accordance with estimates of power computed from characteristics of symbol sequences at baseband

One example of the invention will now be described with reference to the accompanying figures in which;
figure 1 is a representation of a typical burst transmission,
figure 2 is a power profile of a typical burst transmission,
figure 3 is a block diagram of a power control circuit constructed in accordance with the invention
figure 4 is a power metric diagram
figure 5 is a simplified transmitter block diagram
figure 6 is a plot of burst power error versus power metric
figure 7 is a metric determination algorithm

In this example power control means are provided for a pulsed transmitter of a mobile terminal operating with the GSM (Global System for Mobile communications) system in accordance with the method of the invention.

With reference to figure 3 a power control arrangement according to the prior art is shown generally at **1.** An input **2** comprising a modulated signal for transmission is fed to an attenuator **3** and the output from attenuator **3** drives a power amplifier **4.** The output from power amplifier **4** is fed to an antenna (not shown) and transmitted over the air interface. The power delivered to the antenna from the power amplifier is monitored via coupler **5** and detector **6** and a voltage corresponding to the power delivered to the antenna is applied to one input of differential amplifier **7.** A second input to differential amplifier **7** is a reference voltage fed from amplifier **8.** If the voltage level from the detector **6** and the reference voltage from amplifier **8** are the same then any output from differential amplifier **7** will be such as to leave attenuator **3** unchanged. When a difference in the voltage level from the detector **6** and the reference voltage from amplifier **8** occurs, the output from differential amplifier **7** varies the attenuator **3** thereby to reduce or eliminate the difference. By this means the reference voltage from amplifier **8** controls the output power level.

For burst transmissions the switching on and removal of power needs to be implemented in a way that avoids transients or overshoot. A set of so-called ramp profiles are predetermined and stored as a look-up table at **9.** A further set of predetermined values are stored in look-up table **10** and correspond to the power requirements for the transmission according to the network parameters and conditions. Further adjustments may be incorporated either in look-up table **10** or another look-up table (not shown) to account for variations in temperature or component tolerances.

As the training sequence is of a standard format, the power in that part of the burst comprising the training sequence may be controlled more accurately than may the unknown message sequences. Significant power variations can be expected in the message sequences for certain types of modulation. The training sequence is positioned at the centre of the burst and the most stable part of the transmission. Additionally the power variation (peak to average ratio) within the training sequence is less than the power variation within the message sequences.

The power variations within a non-constant envelope modulated signal are illustrated in figure 2 which is a power profile of a typical transmission burst showing power in decibels versus number of samples (time). Precise control of the power level within the training sequence will contribute to the accuracy of the power setting of the burst overall. In order properly to control the overall power of the burst, however, a relationship between the overall power and the power within the training sequence needs to be established.

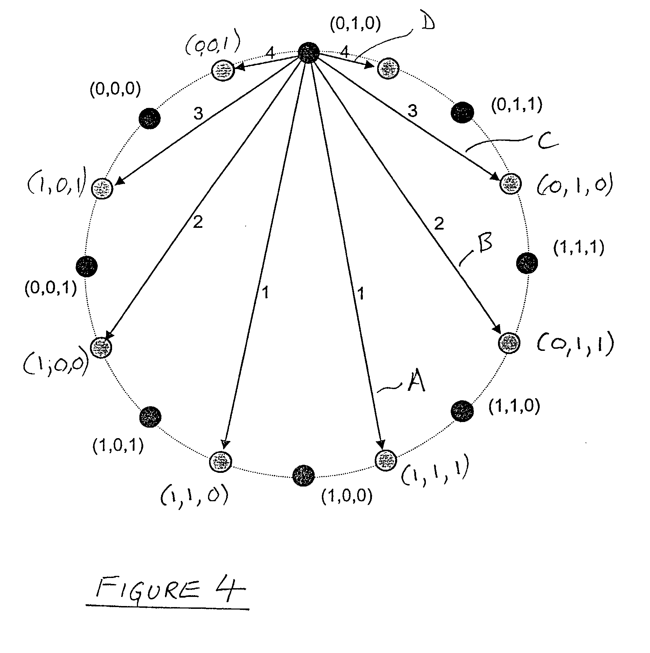

A means of computing estimates of power from a sequence of symbols to be transmitted in a particular burst will now be described with reference to figure 4. The power metric diagram shown in figure 4 is based on a constellation plot for a 3 pi/8 rotated 8-PSK modulation scheme i.e. a non-constant envelope modulation. A series of transitions starting from the symbol comprising bits 0,1,0 to another following symbol is shown. Within this modulation scheme transitions from 0,1,0 to any of the other filled points on the plot are prohibited. The filled points remain on the plot, however, to assist in the description. The contribution to the power in a current symbol from previous and past symbols in the sequence may be computed but only the transition between adjacent symbols in a sequence will be considered here to avoid prolixity.

Consider firstly the transition from 0,1,0 to 1,1,1 as indicated by arrow **A**. This transition has a high peak to average ratio as indicated by the proximity of the arrow **A** to the centre of the plot. For this transition a metric of unity will be assigned to reflect a lower power level. The metric is a value selected from a range of values providing a set of metrics. One of the values (metrics) from the range of values is selected as representing the power level most closely associated with the transition in question.

The power level associated with the transition from 0,1,0 to 0,1,1 as indicated by arrow **B** is higher than transition **A** and the metric assigned to transition **B** is increased to the value 2. Similarly the higher power levels associated with the transitions 0,1,0 to 0,1,0 (arrow C) and 0,1,0 to 0,0,0 (arrow **D**) are accorded metrics of value 3 and 4 respectively. The other metrics shown on the diagram of figure 3 are transitions to 1,1,0 (value 1) 1,0,0 (value 2) 1,0,1 (value 3) and 0,0,1 (value 4).

Other possible transitions from one symbol to another are assigned a metric of value from 1 to 4 on the same basis. Each 3 bit group (each symbol) of the message data sequence is assigned a metric value and the assigned values are summed to provide an integer representative of the power in the message data sequences. The power metrics for the known data of the training sequence, derived in the same way as for the message data sequences, provide a further integer representative of the power in the training sequence.

In view of the limited time from availability of knowledge of specific message data to power setting for transmission of those data, it is necessary to assign metrics and to compute the integer for the message data sequences during the transmission cycle. The integer representative of the training sequence can, if it is convenient to do so, be predetermined and stored.

The power level is measured during the part of the burst during which the training sequence is transmitted. The relationship between the power in the training sequence and the power in the burst overall must be taken into account when the required power level is set.

Referring again to figure 3, the results of the computations are stored in look-up table 11. As the composition of the message data sequences vary from burst to burst then the data stored in look-up table 11 need to be refreshed in advance of power setting and transmission. Any assignments of metrics and associated computations are effected at baseband in order to be able to update the data in look up table 11 before power setting and transmission.

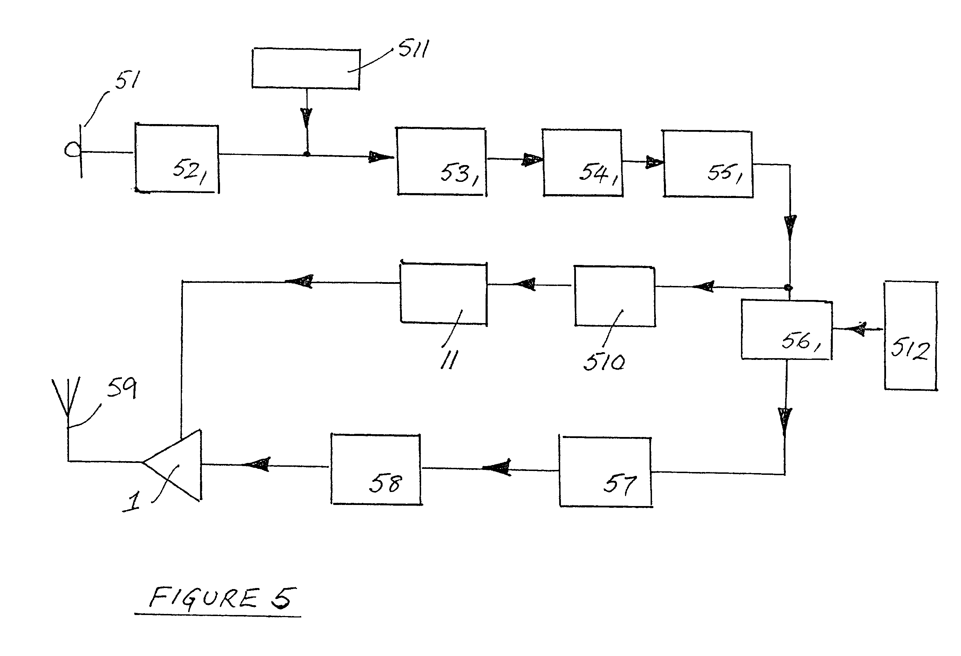

With reference to figure 5 a simplified block diagram of a transmitter is shown and the point at which the metrics and associated computations are obtained is indicated. The data to be transmitted form the input to microphone **51** and in this instance are audio signals such as speech. The input to the transmitter may comprise other types of data input via appropriate input means as are well known in the art.

In accordance with the prior art, voice coding and compression of the input data is effected at **52** and signalling messages added to the compressed data from **511.** Channel coding at **53** is followed by encryption in **54** and the data are then interleaved at **55.** The training sequence is added at the burst building stage **56** and the completed burst is then fed to the modulator **57** and from the modulator to the frequency conversion stage (up-converter) **58.** The modulated RF signal from **58** is applied to the power amplifier stage 1 and then to antenna **59.**

This invention relates to the stage **510** and to the stage **11** which are the metric and computation stage and look-up table respectively. The composition of the training sequence is known and therefore it is not necessary continually to assign metrics in respect of the training sequence.

The composition of the remainder of the burst will have been established before the burst building stage **56** such that metric assignments and associated computations may then proceed.

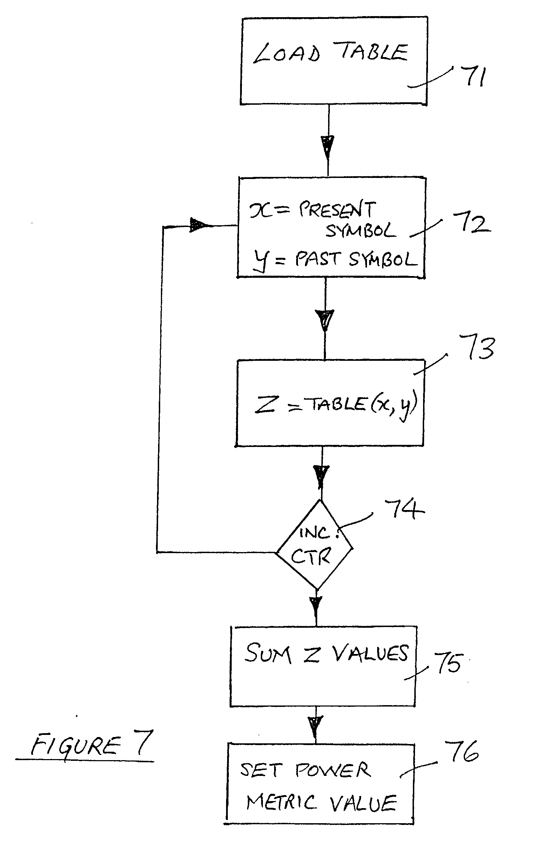

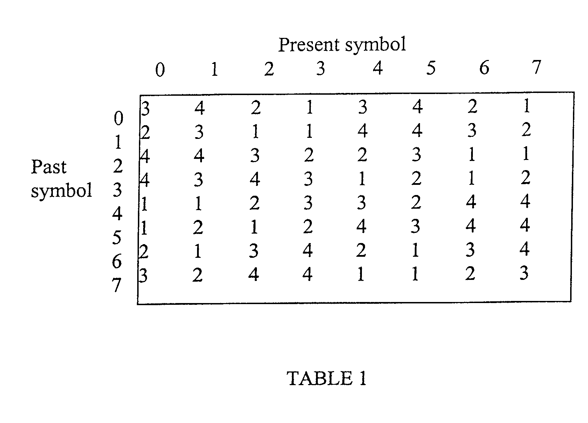

A calibrated power metric is provided in the metric and computation stage **510.** A suitable algorithm for obtaining the power metric is shown in figure 7. At step **71** a standard table of symbol metrics as shown at Table 1 is loaded. This table sets out the metrics for the symbol to symbol transitions. At **72** the present symbol is selected as x and the past symbol is selected as y. The value z =table (x,y) is entered at **73.** The counter is incremented (**74**) and further z values obtained. All of the z values obtained are added at **75** to obtain a power metric and at **76** the power metric is converted by the calibration factor to the output setting. The output from stage **510** is then used to refresh the look-up table **11.** The look-up table **11** and the power amplifier stage **1** are as shown also in figure 3.

The calibration factor applied in stage **510** will depend upon the type of modulation used for the burst transmission and will have been determined empirically. Simulations using typical message data sequences were used to examine the differences in power between the training sequences and the overall RMS power of the burst. Analysis of the results of the simulations suggested that a further improvement in accuracy could be obtained from computation of the simple metrics as are described above. The further improvement is obtained by calibration.

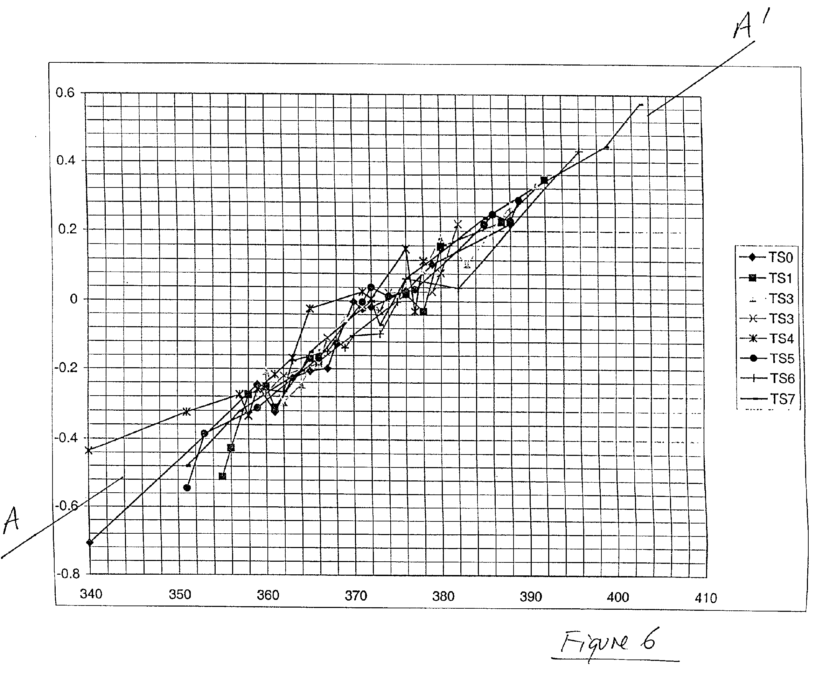

The power metrics for a number of different message data sequences were computed and the burst powers from the transmission of those sequences were measured. All of the bursts contained the same training sequence. A plot of power metric versus error in burst power (RMS) then provided a means for calibration. Further plots were constructed in similar fashion for the remaining seven training sequences and the results of all eight plots are shown in figure 6. A line A-A' represents a simple approximation for the eight plots and provides a gradient of the increase in error with increase in power metric.

The techniques shown herein may be extended to provide a much closer control of burst power than is possible with the simple metrics illustrated.
A more penetrating analysis of the spread of symbol power, taking into account the particular design of the transmitter, will provide for improved estimates of power. The closer control will be achieved, however, at the expense of a significant increase in the processing requirements. In order to achieve a relatively uncomplicated design only transitions from one symbol to the next have been considered here but consideration also of past and future transitions, for example yields a closer estimate of actual power.

The power control loop of the transmission may operate for the whole of the period of the training sequence transmission. Usually, however, it would not be convenient for the power control loop to operate for the complete duration of the training sequence. The affect of adjacent symbols from the message sequences on the first few symbols and the last few symbols of the training sequence can be discounted by limiting the duration of power control to the greater part of the training sequence. Conveniently the power control would not extend to the first and last two or three symbols of the training sequence period.

If it were necessary or desirable to make use of the complete duration of the training sequence for power control, however, then a further adjustment to the power setting may be computed. The further adjustment would be in respect of the interaction between the last **n** symbols of the first message sequence and the first **n** symbols of the training sequence and between the last **n** symbols of the training sequence and the first **n** symbols of the second message sequence. The number **n**=1,2,3,i would be chosen in accordance with the spread of power in the symbols arising from the particular transmitter design.

Furthermore an extension of the duration of power control beyond the training sequence into the message sequences is possible by computation of the perturbation introduced into the relationship between training and message sequences. It may be convenient also to specify the nature of the symbols in the message sequences positioned just before and just after the training sequence. These specified symbols may or may not be part of the message data. The characteristics of the specified symbols will be known and therefore can be selected purposefully such as to restrict the peak to average power with respect to those symbols.

It is possible to make the derivation of the calibration factor more sophisticated. It has been convenient also to use simple integer values for the metrics assigned in this example but other, non-integer values may be assigned as appropriate.

## Claims

1. A method of controlling power of a burst transmission including message and training data sequences, comprising computation of estimates of burst power from the characteristics of the sequences of symbols to be transmitted, setting the power level in accordance with a correlative relationship of power between estimates obtained for said message and training sequences and controlling the transmitted power during part of the transmitted burst.

2. A method as in claim 1 in which the estimates of burst power computed from the characteristics of the sequences of symbols are computed as metrics.

3. A method as in claim 2 in which the metrics are computed on the basis of symbol to symbol transitions.

4. A method as in claim 3 where the metrics are integer values

5. A method of controlling power of a burst transmission as in claims 1 to 4 in which the part of the burst transmission in which the power control means operates is the whole period of the training sequence.

6. A method of controlling power of a burst transmission as in claims 1 to 4 in which the part of the burst transmission in which the power control means operates is the greater part of the period of the training sequence.

7. A portable communications terminal incorporating a burst transmitter power control means consisting of a closed loop operating during part of the burst transmission to maintain output power level in accordance with a reference voltage, the level of said reference voltage being set in accordance with estimates of power computed from characteristics of symbol sequences at baseband.

8. A portable communications terminal as in claim 7 in which the characteristics of symbol sequences computed at baseband are symbol to symbol transitions.

9. A portable communications terminal as in claim 8 in which the computations of characteristics of symbol sequences computed at baseband are metrics.

10. A portable communications terminal as in claim 9 in which the metrics are integer values.

11. A portable communications terminal as in claims 7 to 10 in which the part of the burst transmission in which the power control means operates is the period of the training sequence.

12. A portable communications terminal as in claims 7 to 10 in which the part of the burst transmission in which the power control means operates is the greater part of the period of the training sequence.
